# EUROPEAN PATENT APPLICATION

(11) **EP 1 750 360 A1**
(43) Date of publication of application: **07.02.2007**
(21) Application number: 05405461.4
(22) Date of filing: 03.08.2005
(51) Int. Cl.: H02M 7/00, B60L 9/28, H01F 27/12, H05K 7/20

(54) **Multilevel converter arrangement and use thereof**

(71) Applicant: ABB Research Ltd, 8050 Zürich (CH)
(72) Inventor: Meysenc, Luc, 5405 Baden-Dättwil (CH); Noisette, Philippe, 01630 Sergy (FR); Stefanutti, Philippe, 74330 Choisy (FR); Biller, Peter, 01710 Thoiry (FR); Hugo, Nicolas, 1201 Genève (CH)
(74) Representative: ABB Patent Attorneys

(57) **Abstract**

The present invention is concerned with the cooling of a medium voltage multilevel power electronic converter for converting a single-phase high voltage of a supply line to a lower voltage of a DC link in railway traction applications. The proposed unique cooling circuit is based on the use of the same cooling fluid to cool both the transformer and the power converters of the multilevel converter. This allows to save at least one circulation pump and one heat exchanger as compared to two separate cooling circuits for the converters and the transformer. Due to its intrinsic insulating properties, oil is used as a preferred coolant. Additionally, as the power semiconductor modules are in good thermal and likewise electrical contact with cold plates that are part of the cooling circuit, the cold plates of the different converter levels are at different electrical potential and have to be insulated against each other and against ground potential by means of insulating sections provided in the pipes guiding the coolant to the individual converter levels.

## Description

### FIELD OF THE INVENTION

The invention relates to the field of power converters, and more particular to medium voltage multilevel power electronic converters for single-phase traction applications. It departs from a multilevel converter arrangement with a cooling circuit and more than two converter levels as described in the preamble of claim 1.

### BACKGROUND OF THE INVENTION

Electric railway vehicles such as locomotives or rail coaches powered by an alternating-current (AC) supply line use a traction transformer and an AC/DC converter for converting the high voltage (15 kV or 25 kV) of the supply line to a direct-current (DC) link voltage of a few kV and to ensure a galvanic separation between the high voltage and the traction circuits. A DC link or bus at the DC link voltage feeds the drive or motor converters for traction or propulsion of the vehicle, as well as auxiliary converters for auxiliary energy supply.

In modem railway vehicle concepts, the traction transformer is usually positioned outside the main casing of the vehicle, i.e. under floor or on the rooftop. In these places however, a conventional transformer with a nominal frequency of 16.7 Hz or 50 Hz causes integration problems due to its high weight and large volume. Alternative power supply systems therefore aim at replacing the aforementioned conventional transformer by additional power electronic converters based on semiconductor technology in combination with a smaller and lighter transformer operating at a higher frequency. At the expense of switching losses in the semiconductor devices, the mass and volume of the transformer as well as the total, i.e. copper and magnetic, losses in the transformer can thus be reduced, resulting in a more efficient use of the electrical power from the supply line.

In the patent application EP-A 1 226 994, a medium frequency power supply system for rail vehicles is presented, including a classical converter topology for the bidirectional conversion of an AC input voltage to a DC output voltage. The system comprises a primary converter composed of at least three cascaded converter modules or sections electrically connected in series, one single common transformer and a single secondary converter. Each cascade module in turn is formed by a four-quadrant converter, a 3.6 kV DC intermediate stage and a resonant converter. The secondary or output converter is a resonant switched four-quadrant converter feeding the vehicle's 1.65 kV DC link. All switching elements are advanced 6.5 kV Insulated Gate Bipolar Transistors (IGBT) with an adapted gate driver technology. Instead of passing through a DC intermediate energy storage stage, conversion from the supply line frequency to the transformer frequency can also be accomplished directly by a direct AC frequency converter, also known as a cycloconverter.

In normal power supply of rail vehicles, the cooling of the traction transformer and the power converter are done separately with different cooling systems, including the use of two heat exchangers and circulation pumps as well as two separate heat transfer fluids. Transformers are generally cooled with oil, whereas power converters are often cooled with air or water. Sometimes even more sophisticated coolants like chlorofluorocarbon (CFC) are used to increase the heat transfer capability.

### DESCRIPTION OF THE INVENTION

It is therefore an objective of the invention to simplify the cooling topology in railway traction applications. This objective is achieved by a multilevel converter arrangement and a use thereof according to claims 1 and 5. Further preferred embodiments are evident from the dependent patent claims.

The proposed cooling topology is based on the use of the same cooling or heat transfer fluid, circulating in a single cooling circuit, to cool both the transformer and the power converters of a multilevel converter. At the expense of a possible compromise regarding the properties of the coolant, at least one circulation pump and one heat exchanger can thus be saved as compared to two separate cooling circuits for the converters and the transformer.

In a first preferred variant of the invention, intrinsically insulating oil is used as the cooling fluid. This avoids the need to permanently supervise and occasionally purify a coolant comprising de-ionized water in order to maintain required insulation properties.

In a second preferred embodiment of the invention, the cooling fluid is circulated from the heat exchanger to the converters and subsequently from the converter to the transformer. Hence the lowest temperature and the largest cooling capacity of the coolant are provided to the power semiconductor modules, thus keeping their operating temperature low and increasing their reliability and lifetime.

As the power semiconductor modules are in good thermal and likewise electrical contact with cold plates that are part of the cooling circuit, the cold plates of the different converter levels are at different electrical potential and have to be insulated against each other and against ground potential. Hence, in addition to the insulating cooling fluid, insulating sections made of an electrically insulating material have to be provided in the pipes or tubes guiding the coolant to the individual converter levels.

### BRIEF DESCRIPTION OF THE DRAWINGS

The subject matter of the invention will be explained in more detail in the following text with reference to preferred exemplary embodiments which are illustrated in the attached drawings, in which:
Fig.1 schematically shows a multilevel converter in a traction application, and
Fig.2 depicts a cooling system according to the invention.

The reference symbols used in the drawings, and their meanings, are listed in summary form in the list of reference symbols. In principle, identical parts are provided with the same reference symbols in the figures.

### DETAILED DESCRIPTION OF PREFERRED EMBODIMENTS

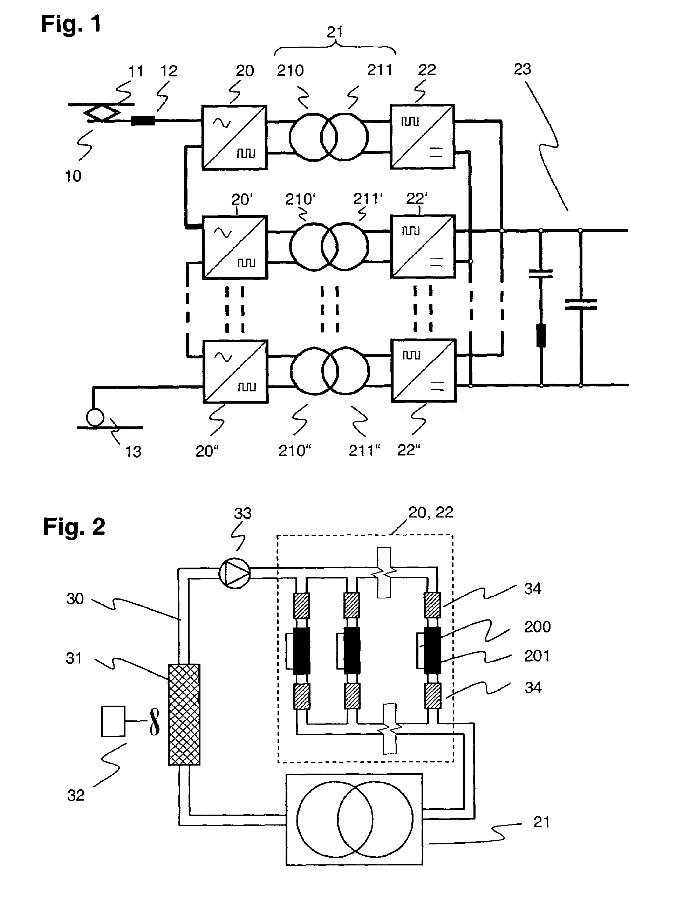

Fig.1 depicts a use of a multilevel power electronic converter in a railway vehicle. A pantograph frame of a current collector 10 is in contact with an overhead supply line 11 of a railway catenary system. The current collector is connected, via a line impedance filter 12, to a first primary converter 20. The latter is connected in series with a second primary converter 20' and further primary converters, wherein the last primary converter 20" is connected, via a wheel 13, to a rail. Each primary converter 20, 20', 20" is further connected to a respective primary winding 210, 210', 210" of a transformer unit of a traction transformer arrangement 21. The transformer units are schematically indicated by two intersecting circles and further comprise secondary windings 211, 211', 211" that in turn are connected to secondary converters 22, 22', 22". Each primary converter 20, 20', 20" and the corresponding transformer windings 210, 211; 210', 211'; 210", 211" and secondary converter 22, 22', 22" form a single AC/DC converter level. All secondary converters 22, 22', 22" are electrically connected in parallel with each other and with a DC link 23.

Fig.2 depicts the cooling topology according to the invention, applied to the multilevel power electronic converter of Fig.1. A single cooling circuit 30 connects a heat exchanger 31 via a circulation pump 33 to both the primary and secondary converters 20, 22 as well as the transformer arrangement 21 of the multilevel converter. A plurality of power semiconductor modules 200 of the converters are in good thermal contact with cold plates 201 through which the cooling fluid flows while circulating in the cooling circuit. Insulating sections 34 are provided between the cold plates, as the latter are generally on different electrical potential. A variable speed ventilator 32 blows air through the heat exchanger 31, whereas another variable speed drive (not depicted) controls the circulation pump 33.

As the cooling fluid with electrically insulating properties, biocompatible or food-grade oil is preferably used. However, attention has to be paid to the ionization of the oil which occurs when oil is circulating in the heat exchangers at a speed exceeding 4 m/s. Hence, the speed of the cooling fluid is regulated by the circulation pump, while a parallel connection of cold plates further allows a control of the flow and a reduction of the oil speed in these elements.

In order to guarantee acceptable operating conditions for the semiconductor modules, the inlet temperature of the oil at the converter cold plates has to be reduced to e.g. 70°C. On the other hand, cooling of the transformer windings to e.g. 100°C is sufficient, hence in a series connection, the converter is positioned right downstream of the heat exchanger and benefits from a larger cooling capacity. To compensate for the higher inlet temperature at the transformer, a longer dwell time of e.g. 1 min in the transformer (as compared to 1 sec in the cold plates) may be arranged for.

In the interior hollow structures of the cold plates, helical guide vanes may be arranged in order to produce a turbulent flow, and/or cooling fins may be arranged in order to improve the heat transfer. On the other hand, the cold plates may be replaced by some other fluid guiding means for providing sufficient cooling capacity to the modules if, for the purpose of electrical insulation, the latter are immersed in the cooling fluid right away.

### LIST OF DESIGNATIOINS

- 10: current collector
- 11: supply line
- 12: line filter
- 13: wheel
- 20, 20', 20": primary converter
- 200: semiconductor module
- 201: cold plate
- 21: traction transformer
- 210, 210', 210": primary winding
- 211, 211', 211": secondary winding
- 22, 22', 22": secondary converter
- 23: DC link
- 30: cooling circuit
- 31: heat exchanger
- 32: ventilator
- 33: circulation pump
- 34: insulating section

## Claims

1. A multilevel converter arrangement with a cooling circuit (30) and N ≥ 2 converter levels, each level comprising a primary converter (20, 20') connected to a primary winding (210, 210') of a transformer unit of a transformer arrangement (21), and a secondary converter (22, 22') connected to a secondary winding (211, 211') of the transformer unit,
**characterized in that** the cooling circuit (30) is connected to both the transformer arrangement (21) and the converters (20, 20', 22, 22') and enables a cooling fluid to circulate between the transformer arrangement (21) and the converters (20, 20', 22, 22').

2. The arrangement according to claim 1, **characterized in that** the cooling fluid circulating in the cooling circuit (30) is oil.

3. The arrangement according to claim 1, wherein the cooling circuit (30) comprises a circulation pump (33) and a heat exchanger (31), **characterized in that** the cooling circuit (30), in a circulation direction of the cooling fluid, serially connects the heat exchanger (31), the converters (20, 20', 22, 22') and the transformer arrangement (21).

4. The arrangement according to claim 1, **characterized in that** cold plates (201) of the primary converters (20, 20') of different converter levels are electrically insulated with respect to each other by means of insulating sections (34) in the cooling circuit (30).

5. A use of a multilevel converter arrangement according to one of claims 1 to 4 for converting a single-phase high voltage of a supply line (11) to a lower voltage of a DC link (23) in railway traction applications, **characterized in that** the transformer units operate at a medium frequency above the frequency of the supply line (11).
